(19) Europäisches Patentamt / European Patent Office / Office européen des brevets

(11) EP 1 943 643 B1

(12) **EUROPEAN PATENT SPECIFICATION**

(45) Date of publication and mention
of the grant of the patent:
**09.10.2019 Bulletin 2019/41**

(21) Application number: **05806493.2**

(22) Date of filing: **04.11.2005**

(51) Int Cl.:
**G10L 19/02** $^{(2013.01)}$

(86) International application number:
**PCT/IB2005/003293**

(87) International publication number:
**WO 2007/052088 (10.05.2007 Gazette 2007/19)**

(54) **AUDIO COMPRESSION**

AUDIO-KOMPRIMIERUNG

COMPRESSION AUDIO

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**16.07.2008 Bulletin 2008/29**

(73) Proprietor: **Nokia Technologies Oy
02610 Espoo (FI)**

(72) Inventor: **TAMMI, Mikko
FI-33720 Tampere (FI)**

(74) Representative: **Cohausz & Florack
Patent- & Rechtsanwälte
Partnerschaftsgesellschaft mbB
Bleichstraße 14
40211 Düsseldorf (DE)**

(56) References cited:
**EP-A- 1 441 330      US-A1- 2004 125 878**

**Description**

Technical Field

The present application relates in general to audio compression.

Background

Audio compression is commonly employed in modern consumer devices for storing or transmitting digital audio signals. Consumer devices may be telecommunication devices, video devices, audio players, radio devices and other consumer devices. High compression ratios enable better storage capacity, or more efficient transmission via a communication channel, i.e. a wireless communication channel, or a wired communication channel. However, simultaneously to the compression ratio, the quality of the compressed signal should be maintained at a high level. The target of audio coding is generally to maximize the audio quality in relation to the given compression ratio, i.e. the bit rate.

Numerous audio coding techniques have been developed during the past decades. Advanced audio coding systems utilize effectively the properties of the human ear. The main idea is that the coding noise can be placed in the areas of the signal where it least affects the perceptual quality, so that the data rate can be reduced without introducing audible distortion. Therefore, theories of psychoacoustics are an important part of modern audio coding.

In known audio encoders, the input signal is divided into a limited number of sub-bands. Each of the sub-band signals can be quantized. From the theory of psychoacoustics it is known that the highest frequencies in the spectrum are perceptually less important than the low frequencies. This can be considered to some extend in the coder by allocating lesser bits to the quantization of the high frequency sub-bands than to the low frequency sub-bands.

More sophisticated audio coding utilizes the fact that in most cases, there are large dependencies between the low frequency regions and high frequency regions of an audio signal, i.e. the higher half of the spectrum is generally quite similar as the lower half. The low frequency region can be considered the lower half of the audio spectrum, and the high frequency can be considered the upper half of the audio spectrum. It is to be understood, that the border between low and high frequency is not fixed, but may lie in between 2kHz and 15kHz, and even beyond these borders.

A current approach for coding the high frequency region is known as spectral-band-replication (SBR). This technique is described in *M. Dietz, L. Liljeryd, K.* Kjorling and O. Kunz, "Spectral Band Replication, a novel approach in audio coding," in 112th AES Convention, Munich, Germany, May, 2002 and P. Ekstrand, "Bandwidth extension of audio signals by spectral band replication," in 1st IEEE Benelux Workshop on Model Based Processing and Coding of Audio, Leuven, Belgium, November 2002. The described method can be applied in ordinary audio coders, such as, for example AAC or MPEG-1 Layer III (MP3) coders, and many other state-of-the-art coders.

EP 1 441 330 discloses encoding an audio signal by encoding a low frequency band, dividing a high frequency band into at least two subbands, determining which lowband sections match best with the high frequency subbands and generating parameters that refer to the best matching lowband sections.

The drawback of the method according to the art is that the mere transposition of low frequency bands to high frequency bands may lead to dissimilarities between the original high frequencies and their reconstruction utilizing the transposed low frequencies. Another drawback is that noise and sinusoids need to be added to the frequency spectrum according to known methods.

Therefore, it is an object of the application to provide an improved audio coding technique. It is a further object of the application to provide a coding technique representing the input signal more correctly with reasonably low bit rates.

Summary

In order to overcome the above mentioned drawbacks, the application provides, according to one aspect, a method for encoding audio signals with receiving an input audio signal, dividing the audio signal into at least a low frequency band and a high frequency band, dividing the high frequency band into at least two high frequency sub-band signals, determining within the low frequency band signal sections which match best with high-frequency sub-band signals, and generating parameters that refer at least to the low frequency band signal sections which match best with high-frequency sub-band signals.

The application provides a new approach for coding the high frequency region of an input signal. The input signal can be divided into temporally successive frames. Each of the frames represents a temporal instance of the input signal. Within each frame, the input signal can be represented by its spectral components. The spectral components, or samples, represent the frequencies within the input signal.

Instead of blindly transposing the low frequency region to the high frequencies, the application maximizes the similarity between the original and the coded high frequency spectral components. According to the application, the high frequency region is formed utilizing the already-coded low frequency region of the signal.

By comparing low frequency signal samples with the high frequency sub-bands of the received signal, a signal section within the low frequency can be found, which matches best with an actual high frequency sub-band. The application provides for searching within the whole low frequency spectrum sample by sample for a signal section, which resembles best a high frequency sub-band. As a signal section corresponds to a sample sequence, the application provides, in other words, finding a sample sequence, which matches best with the high frequency sub-band. The sample sequence can start anywhere within the low frequency band, except that the last considered starting point within the low frequency band should be the last sample in the low frequency band minus the length of the high frequency sub-band that is to be matched.

An index or link to the low frequency signal section matching best the actual high frequency sub-band can be used to model the high frequency sub-band. Only the index or link needs to be encoded and stored, or transmitted in order to allow restoring a representation of the corresponding high frequency sub-band at the receiving end.

According to embodiments, the most similar match, i.e. the most similar spectral shape of the signal section and the high frequency sub-band, is searched within the low frequency band. Parameters referring at least to the signal section which is found to be most similar with a high frequency sub-band are created in the encoder. The parameters may comprise scaling factors for scaling the found sections into the high frequency band. At the decoder side, these parameters are used to transpose the corresponding low frequency signal sections to a high frequency region to reconstruct the high frequency sub-bands.

Scaling can be applied to the copied low frequency signal sections using scaling factors. According to embodiments, only the scaling factors and the links to the low frequency signal sections need to be encoded.

The shape of the high frequency region follows more closely the original high frequency spectrum than with known methods when using the best matching low frequency signal sections for reproduction of the high frequency sub-bands. The perceptually important spectral peaks can be modeled more accurately, because the amplitude, shape, and frequency position is more similar to the original signal. As the modeled high frequency sub-bands can be compared with the original high frequency sub-bands, it is possible to easily detect missing spectral components, i.e. sinusoids or noise, and then add these.

To enable envelope shaping, embodiments provide utilizing the low frequency signal sections by transposing the low frequency signal samples into high-frequency sub-band signals using the parameters wherein the parameters comprise scaling factors such that an envelope of the transposed low frequency signal sections follows an envelope of the high frequency sub-band signals of the received signal. The scaling factors enable adjusting the energy and shape of the copied low frequency signal sections to match better with the actual high frequency sub-bands.

The parameters can comprise links to low frequency signal sections to represent the corresponding high frequency sub-band signals according to embodiments. The links can be pointers or indexes to the low frequency signal sections. With this information, it is possible to refer to the low frequency signal sections when constructing the high frequency sub-band.

In order to reduce the number of quantization bits, it is possible to normalize the envelope of the high frequency sub-band signals. The normalization provides that both the low and high frequency bands are within a normalized amplitude range. This reduces the number of bits needed for quantization of the scaling factors. The information used for normalization has to be provided by the encoder to construct the representation of the high frequency sub-band in the decoder. Embodiments provide envelope normalization with linear prediction coding. It is also possible to normalize the envelope utilizing cepstral modeling. Cepstral modeling uses the inverse Fourier Transform of the logarithm of the power spectrum of a signal.

Generating scaling factors can comprise generating scaling factors in the linear domain to match at least amplitude peaks in the spectrum. Generating scaling factors can also comprise matching at least energy and/or shape of the spectrum in the logarithmic domain, according to embodiments.

Embodiments provide generating signal samples within the low frequency band and/or the high frequency band using modified discrete cosine transformation (MDCT). The MDCT transformation provides spectrum coefficients preferably as real numbers. The MDCT transformation according to embodiments can be used with any suitable frame sizes, in particular with frame sizes of 2048 samples for normal frames and 256 samples for transient frames, but also any other value in between.

To obtain the low frequency signal sections which match best with corresponding high-frequency sub-band signals, embodiments provide calculating a similarity measure using a normalized correlation or the Euclidian distance.

In order to encode the input signal, embodiments provide quantizing the low frequency signal samples and quantizing at least the scaling factors. The link to the low frequency signal section can be an integer.

The invention adds additional sinusoids to improve the quality of high frequency signals. In order to comply with such sinusoids, embodiments provide dividing the input signal into temporally successive frames, and detecting tonal sections within two successive frames within the input signal. The tonal sections can be enhanced by adding additional sinusoids. Sections which are highly tonal can be enhanced additionally by increasing the number of high frequency sub-bands in the corresponding high frequency regions. Input frames can be divided into different tonality groups, e.g. not tonal, tonal, and strongly tonal.

Detecting tonal sections can comprise using Shifted Discrete Fourier Transformation (SDFT). The result of the SDFT can be utilized within the encoder to provide the MDCT transformation.

Another aspect of the application is a method for decoding audio signals with receiving an encoded bit stream, decoding from the bit stream at least a low frequency signal and at least parameters referring to low frequency signal sections, utilizing the low frequency signal samples and the parameters referring to the low frequency signal sections for reconstructing at least two high-frequency sub-band signals, and outputting an output signal comprising at least the low frequency signal and at least the two high-frequency sub-band signals.

A further aspect of the application is an encoder for encoding audio signals comprising receiving means arranged for receiving an input audio signal, filtering means arranged for dividing the audio signal into at least a low frequency band and a high frequency band, and further arranged for dividing the high frequency band into at least two high frequency sub-band signals, and coding means arranged for generating parameters that refer at least to low frequency band signal sections which match best with the high-frequency sub-band signals.

Yet, a further aspect of the application is a decoder for decoding audio signals comprising receiving means arranged for receiving an encoded bit stream, decoding means arranged for decoding from the bit stream at least a low frequency signal and at least parameters referring to the low frequency signal sections, generation means arranged for utilizing samples of the low frequency signal and the parameters referring to the low frequency signal sections for reconstructing at least two high-frequency sub-band signals.

A further aspect of the application is a system for digital audio compression comprising a described decoder, and a described encoder.

Yet, a further aspect of the application relates to a computer program product for encoding audio signals, the program comprising instructions operable to cause a processor to receive an input audio signal, divide the audio signal into at least a low frequency band and a high frequency band, divide the high frequency band into at least two high frequency sub-band signals, and generate parameters that refer at least to low frequency band signal sections which match best with high-frequency sub-band signals.

Also, a computer program product for decoding bit streams, the program comprising instructions operable to cause a processor to receive an encoded bit stream, decode from the bit stream at least a low frequency signal and at least parameters referring to the low frequency signal sections, utilize samples of the low frequency signal and the parameters referring to the low frequency signal sections for reconstructing at least two high-frequency sub-band signals, and put out an output signal comprising at least the low frequency signal and at least two high-frequency sub-band signals.

Brief Description of the Figures

In the figures show:

FIG. 1    a system for coding audio signals according to the art;
FIG. 2    an encoder according to the art;
FIG. 3    a decoder according to the art;
FIG. 4    an SBR encoder;
FIG. 5    an SBR decoder;
FIG. 6    spectral representation of an audio signal in different stages;
FIG. 7    a system according to a first embodiment;
FIG. 8    a system according to a second embodiment;
FIG. 9    a frequency spectrum with envelope normalization;
FIG. 10    coding enhancement using tonal detection.

Detailed Description of the Figures

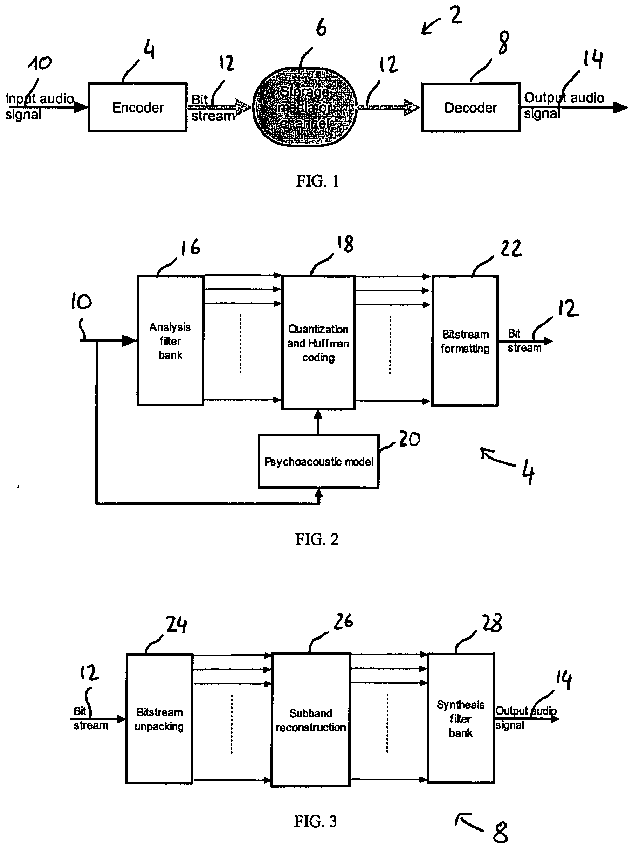

General audio coding systems consist of an encoder and a decoder, as illustrated in schematically FIG. 1. Illustrated is a coding system 2 with an encoder 4, a storage or media channel 6 and a decoder 8.

The encoder 4 compresses an input audio signal 10 producing a bit stream 12, which is either stored or transmitted through a media channel 6. The bit stream 12 can be received within the decoder 8. The decoder 8 decompresses the bit stream 12 and produces an output audio signal 14. The bit rate of the bit stream 12 and the quality of the output audio signal 14 in relation to the input signal 10 are the main features, which define the performance of the coding system 2.

A typical structure of a modern audio encoder 4 is presented schematically in FIG. 2. The input signal 10 is divided into sub-bands using an analysis filter bank structure 16. Each sub-band can be quantized and coded within coding means 18 utilizing the information provided by a psychoacoustic model 20. The coding can be Huffman coding.

The quantization setting as well as the coding scheme can be dictated by the psychoacoustic model 18. The quantized, coded information is used within a bit stream formatter 22 for creating a bit stream 12.

The bit stream 12 can be decoded within a decoder 8 as illustrated schematically in FIG. 3. The decoder 8 can comprise bit stream unpacking means 24, sub-band reconstruction means 26, and a synthesis filter bank 28.

The decoder 8 computes the inverse of the encoder 4 and transforms the bit stream 12 back to an output audio signal 14. During the decoding process, the bit stream 12 is de-quantized in the sub-band reconstruction means 26 into sub-band signals. The sub-band signals are fed to the synthesis filter bank 28, which synthesizes the audio signal from the sub-band signals and creates the output signal 14.

It is in many cases possible to efficiently and perceptually accurately synthesize the high frequency region using only the low frequency region and a limited amount of additional control information. Optimally, the coding of the high frequency part only requires a small number of control parameters. Since the whole upper part of the spectrum can be synthesized with a small amount of information, considerable savings can be achieved in the total bit rate.

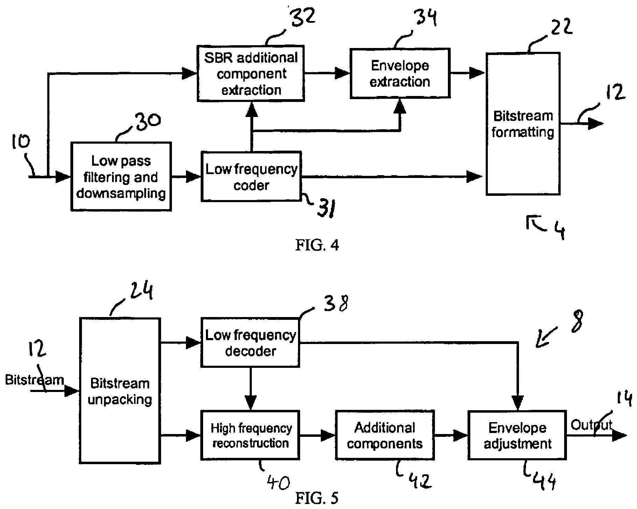

Current coding, such as MP3pro, utilize these properties in audio signals by introducing an SBR coding scheme in addition to the psychoacoustic coding. In SBR, the high frequency region can be generated separately utilizing the coded low frequency region, as illustrated schematically in FIGs 4 and 5.

FIG. 4 illustrates schematically an encoder 4. The encoder 4 comprises low pass filtering means 30, coding means 31, SBR means 32, envelope extraction means 34 and bit stream formatter 22.

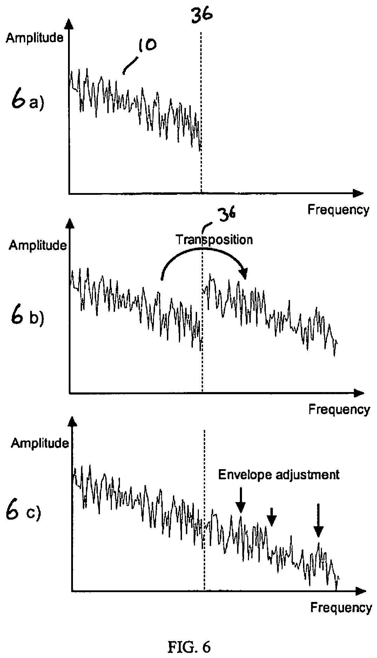

The low pass filter 30 first defines a cut-off frequency up to which the input signal 10 is filtered. The effect is illustrated in FIG. 6a. Only frequencies below the cut-off frequency 36 pass the filter.

The coding means 31 carry out quantization and Huffman coding with 32 low frequency sub-bands. The low frequency contents are converted within coding means 31 into the QMF domain. The low frequency contents are transposed based on the output of coder 31. The transposition is done in SBR means 32. The effect of transposition of the low frequencies to the high frequencies is illustrated within FIG. 6b. The transposition is performed blindly such that the low frequency sub-band samples are just copied into high frequency sub-band samples. This is done similarly in every frame of the input signal and independently of the characteristics of the input signal.

In the SBR means 32, the high frequency sub-bands can be adjusted based on additional information. This is done to make particular features of the synthesized high frequency region more similar with the original one. Additional components, such as sinusoids or noise, can be added to the high frequency region to increase the similarity with the original high frequency region. Finally, the envelope is adjusted in envelope extraction means 34 to follow the envelope of the original high frequency spectrum. The effect can be seen in FIG. 6c, where the high frequency components are scaled to be more closely to the actual high frequency components of the input signal.

Within bit stream 12 the coded low frequency signal together with scaling and envelope adjustment parameters is comprised. The bit stream 12 can be decoded within a decoder as illustrated in FIG. 5.

Fig. 5 illustrates a decoder 8 with unpacking means 24, a low frequency decoder 38, high frequency reconstruction means 40, component adjustment means 42, and envelope adjustment means 44. The low frequency sub-bands are reconstructed in the decoder 38. From the low frequency sub-bands, the high frequency sub-bands are statically reconstructed within high frequency reconstruction means 40. Sinusoids can be added and the envelope adjusted in component adjustment means 42, and envelope adjustment means 44.

According to the application, the transposition of low frequency signal samples into high frequency sub-bands is done dynamically, e.g. it is checked, which low frequency signal sections match best with a high frequency sub-band. An index to the corresponding low frequency signal sections is created. This index is encoded and used within the decoder for constructing the high frequency sub-bands from the low frequency signal.

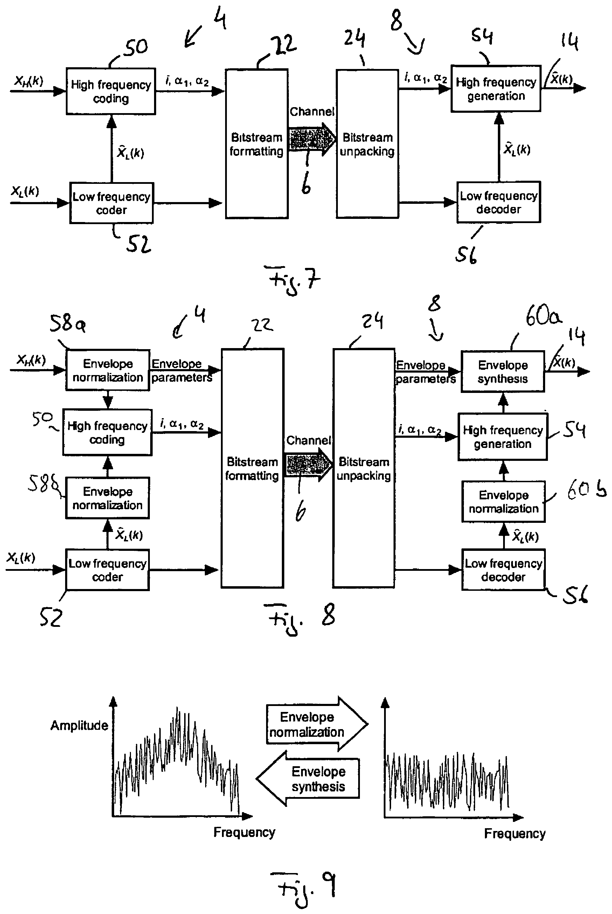

FIG. 7 illustrates a coding system with an encoder 4, and a decoder 8. The encoder 4 is comprised of high frequency coding means 50, a low frequency coder 52, and bit stream formatter 22. The encoder 4 can be part of a more complex audio coding scheme. The application can be used in almost any audio coder in which good quality is aimed at low bit rates. For instance the application can be used totally separated from the actual low bit rate audio coder, e.g. it can be placed in front of a psychoacoustic coder, e.g. AAC, MPEG, etc.

As the high frequency region typically contains similar spectral shapes as the low frequency region, good coding performance is generally achieved. This is accomplished with a relatively low total bit rate, as only the indexes of the copied spectrum and the scaling factors need to be transmitted to the decoder.

Within the low frequency coder 22, the low frequency samples $X_L(k)$ are coded. Within the high frequency coder 50, parameters $\alpha_1$, $\alpha_2$, $i$ representing transformation, scaling and envelope forming are created for coding, as will be described in more detail below.

The high frequency spectrum is first divided into $n_b$ sub-bands. For each sub-band, the most similar match (i.e. the most similar spectrum shape) is searched from the low frequency region.

The method can operate in the modified discrete cosine (MDCT) domain. Due its good properties (50% overlap with critical sampling, flexible window switching etc.), the MDCT domain is used in most state-of-the-art audio coders. The MDCT transformation is performed as:

$$X(k) = \sum_{n=0}^{2N-1} h(n)x(n)\cos\left[\frac{2\pi}{N}(k+\frac{1}{2})(n+\frac{1}{2}+\frac{N}{2})\right], \quad (1)$$

where $x(n)$ is the input signal, $h(n)$ is the time analysis window with length $2N$, and $0 \le k < N$. Typically in audio coding $N$ is 1024 (normal frames) or 128 samples (transients). The spectrum coefficients $X(k)$ can be real numbers. Frame sizes as mentioned, as well as any other frame size are possible.

To create the parameters describing the high frequency sub-bands, it is necessary to find the low frequency signal sections, which match best the high frequency sub-bands within the high frequency coder 50. The high frequency coder 50 and the low frequency coder 52 can create N MDCT coded components, where $X_L(k)$ represents the low frequency components and $X_H(k)$ represent the high frequency components.

With the low frequency coder 52, $N_L$ low frequency MDCT coefficients $\hat{X}_L(k)$, $0 \le k < N_L$ can be coded. Typically $N_L = N/2$, but also other selections can be done.

Utilizing $\hat{X}_L(k)$ and the original spectrum $X(k)$, the target is to create a high frequency component $X_H(k)$ which is, with the used measures, maximally similar with the original high frequency signal $X_H(k) = X(N_L + k)$, $0 \le k < N - N_L$. $\hat{X}_L(k)$ and $X_H(k)$ form together the synthesized spectrum $\hat{X}(k)$:

$$\hat{X}(k) = \begin{cases} \hat{X}_L(k), & 0 \le k < N_L \\ \hat{X}_H(k), & N_L \le k < N \end{cases}. \quad (2)$$

The original high frequency spectrum $X_H(k)$ is divided into $n_b$ non-overlapping bands. In principle, the number of bands as well as the width of the bands can be chosen arbitrarily. For example, eight equal width frequency bands can be used when $N$ equals to 1024 samples. Another reasonable choice is to select the bands based on the perceptual properties of human hearing. For example Bark or equivalent rectangular bandwidth (ERB) scales can be utilized to select the number of bands and their widths.

Within the high frequency coder, the similarity measure between the high frequency signal and the low frequency components can be calculated.

Let $\mathbf{X}_H^j$ be a column vector containing the $j$th band of $X_H(k)$ with length of $w_j$ samples. $\mathbf{X}_H^j$ can be compared with the coded low frequency spectrum $\hat{X}_L(k)$ as follows:

$$\max_{i(j)}\left(S(\hat{\mathbf{X}}_L^{i(j)}, \mathbf{X}_H^j)\right), \quad 0 \le i(j) < N_L - w_j, \quad (3)$$

where $S(a, b)$ is a similarity measure between vectors a and b, and $\hat{\mathbf{X}}_L^{i(j)}$ is a vector containing indexes $i(j) \le k < i(j) + w_j$ of the coded low frequency spectrum $\hat{X}_L(k)$. The length of the desired low frequency signal section is the same as the length of the current high frequency sub-band, thus basically the only information needed is the index i(j), which indicates where a respective low frequency signal section begins.

The similarity measure can be used to select the index $i(j)$ which provides the highest similarity. The similarity measure is used to describe how similar the shapes of the vectors are, while their relative amplitude is not important. There are many choices for the similarity measure. One possible implementation can be the normalized correlation:

$$S(\mathbf{a}, \mathbf{b}) = \left|\frac{\mathbf{b}^T\mathbf{a}}{\sqrt{\mathbf{a}^T\mathbf{a}}}\right|, \quad (4)$$

which provides a measure that is not sensitive to the amplitudes of a and b. Another reasonable alternative is a similarity measure based on Euclidian distance:

$$S(\mathbf{a}, \mathbf{b}) = \frac{1}{\|\mathbf{a} - \mathbf{b}\|}. \quad (5)$$

Correspondingly, many other similarity measures can be utilized as well.

These most similar sections within the low frequency signal samples can be copied to the high frequency sub-bands and scaled using particular scaling factors. The scaling factors take care that the envelope of the coded high frequency spectrum follows the envelope of the original spectrum.

Using the index i(j), a selected vector $\widehat{\mathbf{X}}_L^{i(j)}$, most similar in shape with the $\mathbf{X}_H^j$, has to be scaled to the same amplitude as $\mathbf{X}_H^j$. There are many different techniques for scaling. For example, scaling can be performed in two phases, first in the linear domain to match the high amplitude peaks in the spectrum and then in the logarithmic domain to match the energy and shape. Scaling the vector $\widehat{\mathbf{X}}_L^{i(j)}$ with these scaling factors results in the coded high frequency component $\widehat{\mathbf{X}}_H^j$.

The linear domain scaling is performed simply as

$$\widehat{\mathbf{X}}_H^j = \alpha_1(j)\widehat{\mathbf{X}}_L^{i(j)}, \qquad (6)$$

where $\alpha_1(j)$ is obtained from

$$\alpha_1(j) = \frac{(\widehat{\mathbf{X}}_L^{i(j)})^T \mathbf{X}_H^j}{(\widehat{\mathbf{X}}_L^{i(j)})^T \widehat{\mathbf{X}}_L^{i(j)}}. \qquad (7)$$

Notice, that $\alpha_1(j)$ can get both positive and negative values. Before logarithmic scaling, the sign of vector samples as well as the maximum logarithmic value of $\widehat{\mathbf{X}}_H^j$ can be stored:

$$\mathbf{K}_{\widehat{\mathbf{X}}_H^j} = \frac{\widehat{\mathbf{X}}_H^j}{\left|\widehat{\mathbf{X}}_H^j\right|} \qquad (8)$$

$$M_{\widehat{\mathbf{X}}_H^j} = \max\left(\log_{10}\left|\widehat{\mathbf{X}}_H^j\right|\right) \qquad (9)$$

Now, the logarithmic scaling can be performed and $\widehat{\mathbf{X}}_H^j$ is updated as

$$\mathbf{V}_{\widehat{\mathbf{X}}_H^j} = \alpha_2(j)(\log_{10}\left(\left|\widehat{\mathbf{X}}_H^j\right|\right) - M_{\widehat{\mathbf{X}}_H^j}) + M_{\widehat{\mathbf{X}}_H^j}, \qquad (10)$$

$$\widehat{\mathbf{X}}_H^j = 10^{\mathbf{V}_{\widehat{\mathbf{X}}_H^j}}(\mathbf{K}_{\widehat{\mathbf{X}}_H^j})^T, \qquad (11)$$

where the scaling factor $\alpha_2(j)$ is obtained from

$$\alpha_2(j) = \frac{\left(\log_{10}\left(\left|\widehat{\mathbf{X}}_H^j\right|\right) - M_{\widehat{\mathbf{X}}_H^j}\right)^T \left(\log_{10}\left(\left|\mathbf{X}_H^j\right|\right) - M_{\widehat{\mathbf{X}}_H^j}\right)}{\left(\log_{10}\left(\left|\widehat{\mathbf{X}}_H^j\right|\right) - M_{\widehat{\mathbf{X}}_H^j}\right)^T \left(\log_{10}\left(\left|\widehat{\mathbf{X}}_H^j\right|\right) - M_{\widehat{\mathbf{X}}_H^j}\right)}. \qquad (12)$$

This scaling factor maximizes similarity between waveforms in the logarithmic domain. Alternatively, $\alpha_2(j)$ can be selected such that the energies are set to the approximately equal level:

$$\alpha_2(j) = \frac{\left\| \log_{10}(\mathbf{X}_H^j) - M_{\tilde{\mathbf{X}}_H^j} \right\|}{\left\| \log_{10}(\widehat{\mathbf{X}}_H^j) - M_{\tilde{\mathbf{X}}_H^j} \right\|} . \quad (13)$$

In the above equations, the purpose of the variable $M_{\tilde{\mathbf{X}}_H^j}$ is to make sure that the amplitudes of the largest values in $\widehat{\mathbf{X}}_H^j$ (i.e. the spectral peaks) are not scaled too high (the first scaling factor $\alpha_1(j)$ did already set them to the correct level). Variable $\mathbf{K}_{\tilde{\mathbf{X}}_H^j}$ is used to store the sign of the original samples, since that information is lost during transformation to the logarithmic domain.

After the bands have been scaled, the synthesized high frequency spectrum $X_H(k)$ can be obtained by combining vectors $\widehat{\mathbf{X}}_H^j$, $j = 0, 1, ..., n_b - 1$.

After the parameters have been selected, the parameters need to be quantized for transmitting the high frequency region reconstruction information to the decoder 8.

To be able to reconstruct $X_H(k)$ in the decoder 8, parameters $i(j)$, $\alpha_1(j)$ and $\alpha_2(j)$ are needed for each band. In the decoder 8, a high frequency generation means 54 utilize these parameters. Since index $i(j)$ is an integer, it can be submitted as such. $\alpha_1(j)$ and $\alpha_2(j)$ can be quantized using for example a scalar or vector quantization.

The quantized versions of these parameters, $\bar{\alpha}_1(j)$, and $\widehat{\alpha}_2(j)$, are used in the high frequency generation means 54 to construct $X_H(k)$ according to equations (6) and (10).

A low frequency decoding means 56 decodes the low frequency signal and together with the reconstructed high frequency sub-bands form the output signal 14 according to equation 2.

The system as illustrated in FIG. 7 may further be enhanced with means for envelope normalization. The system illustrated in FIG. 8 comprises in addition to the system illustrated in FIG. 7 envelope normalization means 58 and envelope synthesis means 60

In this system, the high frequency coding technique is used to generate an envelope-normalized spectrum using the envelope normalization means 58 in the encoder 4. The actual envelope synthesis is performed in a separate envelope synthesis means 60 in the decoder 8.

The envelope normalization can be performed utilizing, for example, LPC-analysis or cepstral modeling. It should be noted that with envelope normalization, envelope parameters describing the original high frequency spectral envelope have to be submitted to the decoder, as illustrated in FIG. 8.

In SBR, additional sinusoids and noise components are added to the high frequency region. It is possible to do the same also in the above described application. If necessary, additional components can be added easily. This is because in the described method it is possible to measure the difference between the original and synthesized spectra and thus to find locations where there are significant differences in the spectral shape. Since, for example, in common BWE coders the spectral shape differs significantly from the original spectrum it is typically more difficult to decide whether additional sinusoidal or noise components should be added.

It has been noticed that in some cases when the input signal is very tonal, the quality of the coded signal may decrease when compared to the original. This is because the coded high frequency region may not remain as periodic from one frame to another as in the original signal. The periodicity is lost since some periodic (sinusoidal) components may be missing or the amplitude of the existing periodic components varies too much from one frame to another.

To include tonal sections even when the low frequency signal samples used for reconstructing the high frequency sub-bands do not represent the entire sinusoidal, two further steps can be provided.

In a first step, the tonal signal sections with possible quality degradations can be detected. The tonal sections can be detected by comparing the similarities between two successive frames in the Shifted Discrete Fourier Transform (SDFT) domain. SDFT is a useful transformation for this purpose, because it contains also phase information, but is still closely related to the MDCT transformation, which is used in the other parts of the coder.

Tonality detection can be performed right after transient detection and before initializing the actual high frequency region coding. Since transient frames do generally not contain tonal components, tonality detection can be applied only when both present and previous frames are normal long frames (e.g. 2048 samples).

The tonality detection is based on Shifted Discrete Fourier Transform (SDFT), as indicated above, which can be defined for 2N samples long frames as:

$$Y(k) = \sum_{n=0}^{2N-1} h(n)x(n)\exp\left(i2\pi(n+u)(k+v)/2N\right), \quad (14)$$

where h(n) is the window, x(n) is the input signal, and u and v represent time and frequency domain shifts, respectively. These domain shifts can be selected such that u = (N + 1)/2 and v = 1/2, since then it holds that $X(k)$=real($Y(k)$).

Thus, instead of computing SDFT and MDCT transformations separately, the SDFT transformation can be computed first for the tonality analysis and then the MDCT transformation is obtained straightforwardly as a real part of the SDFT coefficients. This way the tonality detection does not increase computational complexity significantly.

With $Y(k)_b$ and $Y(k)_{b-1}$ representing the SDFT transformation of current and previous frames, respectively, the similarity between frames can be measured using:

$$S = \frac{\sum_{k=N_l+1}^{N}\left(|Y_b(k)| - |Y_{b-1}(k)|\right)^2}{\sum_{k=N_L+1}^{N}\left(|Y_b(k)|\right)^2}, \quad (15)$$

where $N_l+1$ corresponds to the limit frequency for high frequency coding. The smaller the parameter S is, the more similar the high frequency spectrums are. Based on the value of S, frames can be classified as follows:

$$\text{TONALITY} = \begin{cases} \text{STRONGLY TONAL,} & 0 \le S < s_{\text{lim}1} \\ \text{TONAL,} & s_{\text{lim}1} \le S < s_{\text{lim}2} \\ \text{NOT TONAL,} & s_{\text{lim}2} \le S \end{cases}. \quad (16)$$

Good choices for the limiting factors slim1 and slim2 are 0.02 and 0.2, respectively. However, also other choices can be made. In addition, different variants can be used and, for example, one of the classes can be totally removed.

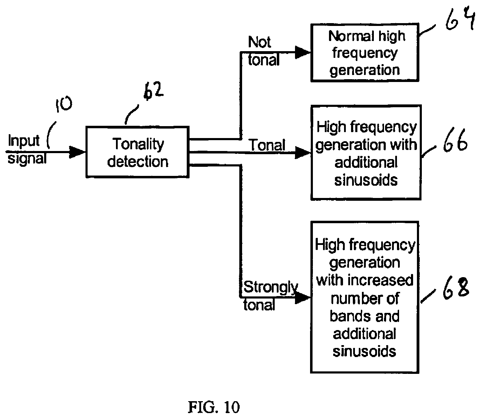

As illustrated in FIG. 10, the tonal detection (62) as described above can be carried out based on the input signal 10.

Based on the tonality detection (62), the input frames are divided into three groups: not tonal (64), tonal (66) and strongly tonal (66), as illustrated in FIG. 10.

After tonal detection (62), in a second step the quality of the tonal sections can be improved by adding additional sinusoids to the high frequency region and possibly by increasing the number of high frequency sub-bands used to create the high frequency region as described above.

The most typical case is that the signal is not tonal (64), and then the coding is continued as described above.

If the input signal is classified as tonal (66), additional sinusoids can be added to the high frequency spectrum after applying the coding as illustrated above. A fixed number of sinusoids can be added to the MDCT domain spectrum. The sinusoids can straightforwardly be added to the frequencies where the absolute difference between the original and the coded spectrum is largest. The positions and amplitudes of the sinusoids are quantized and submitted to the decoder.

When a frame is detected to be tonal (or strongly tonal), sinusoids can be added to the high frequency region of the spectrum. With $X_H(k)$ and $X_H(k)$ representing the original and coded high frequency sub-band components, respectively, the first sinusoid can be added to index $k_1$, which can be obtained from

$$\max_{k_t}\left|X_H(k_t) - \hat{X}_H(k_t)\right|. \quad (17)$$

The amplitude (including its sign) of the sinusoid can be defined as

$$A_t = X_H(k_t) - \hat{X}_H(k_t). \quad (18)$$

Finally, $\hat{X}_H(k)$ can be updated as

$$\hat{X}_H(k_i) = \hat{X}_H(k_i) + A_i \ . \qquad (19)$$

Equations (17) - (19) can be repeated until a desired number of sinusoids have been added. Typically, already four additional sinusoids can result in clearly improved results during tonal sections. The amplitudes of the sinusoids $A_i$ can be quantized and submitted to the decoder 8. The positions $k_i$ of the sinusoids can also be submitted. In addition, the decoder 8 can be informed that the current frame is tonal.

It has been noticed that during tonal sections the second scaling factor $\alpha_2$ may not improve the quality and may then be eliminated.

When a strongly tonal section (68) is detected, it is known that the current section is particularly challenging for high frequency region coding. Therefore, adding just sinusoids may not be enough. The quality can be further improved by increasing the accuracy of the high frequency coding. This can be performed by adding the number of bands used to create the high frequency region.

During strongly tonal sections, the high frequency sub-bands remain very similar from one frame to another. To maintain this similarity also in the coded signal, special actions can be applied. Especially if the number of high frequency sub-bands nb is relatively low (i.e. 8 or below), the number of high frequency sub-bands can be increased to higher rates. For example, 16 high frequency sub-bands generally provide performance that is more accurate.

In addition to a high number of bands, also a high number of sinusoids can be added. In general, a good solution is to use two times as many sinusoids as during "normal" tonal sections.

Increasing the number of high frequency sub-bands as well as increasing the number of sinusoids easily doubles the bit rate of strongly tonal sections when compared to "normal" frames. However, strongly tonal sections are a very special case and do occur very rarely, thus the increase to the average bit rate is very small.

**Claims**

1. Method for encoding audio signals with:

   receiving an input audio signal;
   dividing the input audio signal into at least a low frequency band and a high frequency band;
   dividing the high frequency band into at least two high frequency sub-band signals;
   determining a similarity measure between low frequency band signal sections and the high frequency sub-band signals by comparing low frequency signal samples with high frequency sub-bands of the received input audio signal;
   coding low frequency signal samples of the low frequency signal band ;
   generating parameters that refer at least to the low frequency band signal sections having the highest similarity measure with respect to the high-frequency sub-band signals, for transposing the low frequency band signal sections to a high frequency to reconstruct the high frequency sub-bands;
   dividing the input audio signal into temporally successive frames;
   detecting tonal sections within two successive frames within the input audio signal, and, if tonal sections are detected, adding sinusoids to the high frequency region; and
   creating a bitstream with the coded low frequency signal samples, the parameters and, if tonal sections are detected, positions and amplitudes of the sinusoids.

2. Method of claim 1, wherein generating parameters further comprises generating at least one scaling factor for scaling the low frequency band signal sections.

3. Method of claim 2, wherein the scaling factor is generated such that an envelope of the low frequency signal sections being transposed into the high frequency sub-band signals using the parameters follows an envelope of the high frequency sub-band signal of the received input audio signal.

4. Method of claim 2, wherein generating scaling factors comprises generating scaling factors in the linear domain to match at least amplitude peaks in the spectrum.

5. Method of claim 2, wherein generating scaling factors comprises generating scaling factors in the logarithmic domain to match at least energy and/or shape of the spectrum.

6. Method of claim 1, wherein generating parameters comprises generating links to low frequency signal sections which represent the corresponding high frequency sub-band signals.

7. Method of claim 1, wherein determining within the low frequency band signal sections which match best with high frequency sub-band signals comprises using at least one of

    A) normalized correlation,
    B) Euclidian distance.

8. Method of claim 1, wherein at least samples of the low frequency signal sections are generated using modified discrete cosine transformation.

9. Method of claim 1, further comprising normalizing the envelope of the high frequency sub-band signals.

10. Method of claim 2, further comprising quantizing samples of the low frequency signal and quantizing at least the scaling factors.

11. Method of claim 1, wherein detecting tonal sections comprises using a shifted discrete fourier transform.

12. Method of claim 1, further comprising increasing the number of high frequency sub-bands for tonal sections.

13. Method for decoding audio signals with:

receiving an encoded bit stream;
decoding from the bit stream at least a low frequency signal and at least parameters referring to low frequency signal sections and, wherein the parameters refer at least to the low frequency band signal sections having the highest similarity measure with respect to a high-frequency sub-band signal, for transposing the low frequency band signal sections to a high frequency to reconstruct the high frequency sub-bands; unpacking from the bitstream positions and amplitudes of sinusoids if positions and amplitudes of sinusoids are included in the bitstream,
utilizing samples of the low frequency signal and the parameters referring to the low frequency signal sections and, if included in the bitstream, positions and amplitudes of sinusoids for reconstructing at least two high frequency sub-band signals; and
outputting an output audio signal comprising at least the low frequency signal and the at least two high frequency sub-band signals, wherein the at least two high-frequency sub-bands are reconstructed from the at least one decoded low frequency signal, the parameters, and, if included in the bitstream, the positions and amplitudes of the sinusoids.

14. Encoder for encoding audio signals comprising:

receiving means arranged for receiving an input audio signal;
filtering means arranged for dividing the input audio signal into at least a low frequency band and a high frequency band, for dividing the high frequency band into at least two high frequency sub-band signals, and further arranged for dividing the input audio signal into temporally successive frames, for detecting tonal sections within two successive frames within the input audio signal; and
coding means arranged for determining a similarity measure between low frequency band signal sections and the high-frequency sub-band signals by comparing low frequency signal samples with high frequency sub-bands of the received input audio signal, for generating parameters that refer at least to the low frequency bands signal sections having the highest similarity measure with respect to the high-frequency sub-bands signals, for transposing the low frequency band signal sections to a high frequency to reconstruct the high frequency sub-bands, and, if tonal sections are detected, adding sinusoids to the high frequency region,the coding means further arranged for coding low frequency signal samples of the low frequency signal band, and
output means for creating a bitstream with the coded low frequency signal samples, the parameters and, if tonal sections are detected, positions and amplitudes of the sinusoids.

15. Encoder of claim 14, wherein the coding means are arranged for generating at least one scaling factor for scaling the low frequency band signal sections.

16. Encoder of claim 14, wherein the coding means are arranged for generating the scaling factor such that an envelope of the low frequency signal sections being transposed into high frequency sub-band signals using the parameters follows an envelope of the high frequency sub-band signals of the received signal.

17. Encoder of claim 14, wherein the filtering means are arranged for detecting tonal sections using Shifted Discrete Fourier Transformation.

18. Encoder of claim 14, wherein the coding means are arranged for increasing the number of high frequency sub-bands for tonal sections.

19. Decoder for decoding audio signals comprising:

receiving means arranged for receiving an encoded bit stream;
decoding means arranged for decoding from the bit stream at least a low frequency signal and at least parameters referring to low frequency signal sections, and for unpacking from the bitstream positions and amplitudes of sinusoids if positions and amplitudes of sinusoids are included in the bitstream, wherein the parameters refer at least to the low frequency band signal sections having the highest similarity measure with respect to a high-frequency sub-band signal, for transposing the low frequency band signal sections to a high frequency to reconstruct the high frequency sub-bands; and
generation means arranged for utilizing samples of the low frequency signal and the parameters referring to the low frequency signal sections and, if included in the bitstream, positions and amplitudes of sinusoids for reconstructing at least two high frequency sub-band signals, outputting means arranged for outputting an output audio signal comprising the at least one decoded low frequency signal and the at least two high frequency sub-band signals,
wherein the at least two high-frequency sub-bands are reconstructed from the at least one decoded low frequency signal, the parameters, and, if included in the bitstream, the positions and amplitudes of the sinusoids.

20. System for digital audio compression comprising a decoder according to claim 19, and an encoder according to claim 14.

21. Computer program product for encoding audio signals, the program comprising instructions operable to cause a processor to:

receive an input audio signal;
divide the input audio signal into at least a low frequency band and a high frequency band;
divide the high frequency band into at least two high frequency sub-band signals;
determine a similarity measure between low frequency band signal sections and the high frequency sub-band signals by comparing low frequency signal samples with high frequency sub-bands of the received input audio signal;
coding low frequency signal samples of the low frequency signal band;
generate parameters that refer at least to the low frequency band signal sections having the highest similarity measure with respect to the high-frequency sub-band signals, for transposing the low frequency band signal sections to a high frequency to reconstruct the high frequency sub-bands;
divide the input audio signal into temporally successive frames;
detect tonal sections within two successive frames within the input audio signal, and, if tonal sections are detected, adding sinusoids to the high frequency region; and
create a bitstream with the coded low frequency signal samples, the parameters and, if tonal sections are detected, positions and amplitudes of the sinusoids.

22. Computer program product of claim 21, wherein detecting tonal sections comprises using a shifted discrete fourier transformation for detecting tonal sections.

23. Computer program product of claim 21, operable to cause a processor to increase the number of high frequency sub-bands for tonal sections.

24. Computer program product for decoding bit streams, the program comprising instructions operable to cause a processor to:

> receive an encoded bit stream;
>
> decode from the bit stream at least a low frequency signal and at least parameters referring to low frequency signal sections, wherein the parameters refer at least to the low frequency band signal sections having the highest similarity measure with respect to high-frequency sub-band signal, for transposing the low frequency band signal sections to a high frequency to reconstruct the high frequency sub-bands;
>
> unpacking from the bitstream positions and amplitudes of sinusoids if positions and amplitudes of sinusoids are included in the bitstream;
>
> utilize samples of the low frequency signal and the parameters referring to the low frequency signal sections and, if included in the bitstream, positions and amplitudes of sinusoids for reconstructing at least two high frequency sub-band signals; and
>
> output an output audio signal comprising at least the low frequency signal and the at least two high frequency sub-band signals, wherein the at least two high-frequency sub-bands are reconstructed from the at least one decoded low frequency signal, the parameters, and, if included in the bitstream, the positions and amplitudes of the sinusoids.

**Patentansprüche**

1.  Verfahren zur Codierung von Audiosignalen mit:

    > Empfangen eines Eingabeaudiosignals;
    >
    > Unterteilen des Eingabeaudiosignals in mindestens ein Niederfrequenzband und ein Hochfrequenzband;
    >
    > Unterteilen des Hochfrequenzbands in mindestens zwei Hochfrequenzzwischenbandsignale;
    >
    > Bestimmen eines Ähnlichkeitsmaßes zwischen Niederfrequenzbandsignalabschnitten und den Hochfrequenzzwischenbandsignalen durch Vergleich von Niederfrequenzsignalsamples mit Hochfrequenzzwischenbändern des empfangenen Eingabeaudiosignals;
    >
    > Codieren von Niederfrequenzsignalsamples des Niederfrequenzsignalbands;
    >
    > Erzeugen von Parametern, die sich mindestens auf die Niederfrequenzbandsignalabschnitte beziehen, die das höchste Ähnlichkeitsmaß bezüglich der Hochfrequenzzwischenbandsignale aufweisen, um die Niederfrequenzbandsignalabschnitte auf eine Hochfrequenz zu transponieren, um die Hochfrequenzzwischenbänder zu rekonstruieren;
    >
    > Teilen des Eingabeaudiosignals in temporär sukzessive Rahmen;
    >
    > Erkennen von Tonabschnitten innerhalb von zwei aufeinanderfolgenden Rahmen innerhalb des Eingabeaudiosignals, und, wenn Tonabschnitte erkannt werden, Hinzufügen von Sinuskurven zu der Hochfrequenzregion; und
    >
    > Erzeugen eines Bitstreams mit den codierten Niederfrequenzsignalsamples, den Parametern und, wenn Tonabschnitte erkannt werden, von Positionen und Amplituden der Sinuskurve.

2.  Verfahren nach Anspruch 1, wobei das Erzeugen von Parametern ferner das Erzeugen von mindestens einem Skalierungsfaktor zum Skalieren der Niederfrequenzbandsignalabschnitte umfasst.

3.  Verfahren nach Anspruch 2, wobei der Skalierungsfaktor so erzeugt wird, dass eine Hüllkurve der Niederfrequenzsignalabschnitte, die unter Verwendung der Parameter in die Hochfrequenzzwischenbandsignale transponiert werden, einer Hüllkurve des Hochfrequenzzwischenbandsignals des empfangenen Eingabeaudiosignals folgt.

4.  Verfahren nach Anspruch 2, wobei das Erzeugen von Skalierungsfaktoren das Erzeugen von Skalierungsfaktoren in der linearen Domäne umfasst, um mindestens Amplitudenspitzen in dem Spektrum zu entsprechen.

5.  Verfahren nach Anspruch 2, wobei das Erzeugen von Skalierungsfaktoren das Erzeugen von Skalierungsfaktoren in der logarithmischen Domäne umfasst, um mindestens der Energie und/oder Form des Spektrums zu entsprechen.

6.  Verfahren nach Anspruch 1, wobei das Erzeugen von Parametern umfasst, Verbindungen zu Niederfrequenzsignalabschnitten zu erzeugen, die die entsprechenden Hochfrequenzzwischenbandsignale darstellen.

7.  Verfahren nach Anspruch 1, wobei das Bestimmen innerhalb der Niederfrequenzbandsignalabschnitte, die am besten zu den Hochfrequenzzwischenbandsignalen passen, die Verwendung von mindestens einem der folgenden umfasst:

A) normalisierte Korrelation,
B) euklidischer Abstand.

**8.** Verfahren nach Anspruch 1, wobei mindestens Samples der Niederfrequenzsignalabschnitte unter Verwendung modifizierter diskreter Kosinustransformation erzeugt werden.

**9.** Verfahren nach Anspruch 1, ferner umfassend die Normalisierung der Hüllkurve der Hochfrequenzzwischenbandsignale.

**10.** Verfahren nach Anspruch 2, ferner umfassend das Quantifizieren von Samples des Niederfrequenzsignals und Quantisieren von mindestens den Skalierungsfaktoren.

**11.** Verfahren nach Anspruch 1, wobei das Erkennen von Tonabschnitten das Verwenden einer verschobenen diskreten Fouriertransformation umfasst.

**12.** Verfahren nach Anspruch 1, ferner umfassend das Erhöhen der Anzahl von Hochfrequenzzwischenbändern für Tonabschnitte.

**13.** Verfahren zur Decodierung von Tonsignalen mit:

Empfangen eines codierten Bitstreams;
Decodieren von mindestens einem Niederfrequenzsignal und mindestens Parametern, die sich auf Niederfrequenzsignalabschnitte beziehen, aus dem Bitstream und wobei sich die Parameter mindestens auf die Niederfrequenzbandsignalabschnitte beziehen, die das höchste Ähnlichkeitsmaß bezüglich eines Hochfrequenzzwischenbandsignals aufweisen, um die Niederfrequenzbandsignalabschnitte auf eine Hochfrequenz zu transponieren, um die Hochfrequenzzwischenbänder zu rekonstruieren;
Entpacken von Positionen und Amplituden der Sinuskurven, wenn Positionen und Amplituden von Sinuskurven in dem Bitstream enthalten sind,
Verwenden von Samples des Niederfrequenzsignals und der Parameter, die sich auf die Niederfrequenzsignalabschnitte beziehen und, wenn sie in dem Bitstream enthalten sind, Positionen und Amplituden von Sinuskurven zur Rekonstruktion von mindestens zwei Hochfrequenzzwischenbandsignalen; und
Ausgeben eines Ausgabeaudiosignals, das mindestens das Niederfrequenzsignal und mindestens zwei Hochfrequenzzwischenbandsignale umfasst, wobei die mindestens zwei Hochfrequenzzwischenbänder aus dem mindestens einen decodierten Niederfrequenzsignal, den Parametern und, wenn sie in dem Bitstream enthalten sind, den Positionen und Amplituden der Sinuskurve rekonstruiert werden.

**14.** Encoder zum Codieren von Tonsignalen, umfassend:

Empfangsmittel, angeordnet zum Empfangen eines Eingabeaudiosignals;
Filtermittel, angeordnet zum Unterteilen des Eingabeaudiosignals in mindestens ein Niederfrequenzband und ein Hochfrequenzband, zum Unterteilen des Hochfrequenzbands in mindestens zwei Hochfrequenzzwischenbandsignale, und ferner angeordnet zum Unterteilen des Eingabeaudiosignals in temporär sukzessive Rahmen, um Tonabschnitte innerhalb von zwei sukzessiven Rahmen innerhalb des Eingabeaudiosignals zu erkennen; und
Codierungsmittel, angeordnet zum Bestimmen eines Ähnlichkeitsmaßes zwischen Niederfrequenzbandsignalabschnitten und den Hochfrequenzzwischenbandsignalen durch Vergleich von Niederfrequenzsignalsamples mit Hochfrequenzzwischenbändern des empfangenen Eingabeaudiosignals, zum Erzeugen von Parametern, die sich mindestens auf die Niederfrequenzbandsignalabschnitte beziehen, die das höchste Ähnlichkeitsmaß bezüglich der Hochfrequenzzwischenbandsignale aufweisen, um die Niederfrequenzbandsignalabschnitt auf die Hochfrequenz zu transponieren, um die Hochfrequenzzwischenbänder zu konstruieren und, wenn Tonabschnitte erkannt sind, Hinzufügen von Sinuskurven zu der Hochfrequenzregion, wobei das Codierungsmittel ferner angeordnet ist, um Niederfrequenzsignalsamples des Niederfrequenzsignalbands zu codieren, und
Ausgabemittel zum Erzeugen eines Bitstreams mit den codierten Niederfrequenzsignalsamples, den Parametern und, wenn Tonabschnitte erkannt werden, von Positionen und Amplituden der Sinuskurve.

**15.** Encoder nach Anspruch 14, wobei die Codierungsmittel zum Erzeugen von mindestens einem Skalierungsfaktor zur Skalierung der Niederfrequenzbandsignalabschnitte angeordnet sind.

16. Encoder nach Anspruch 14, wobei die Codierungsmittel zum Erzeugen des Skalierungsfaktors angeordnet sind, sodass eine Hüllkurve der Niederfrequenzsignalabschnitte, die unter Verwendung der Parameter in Hochfrequenzzwischenbandsignale transponiert werden, einer Hüllkurve der Hochfrequenzzwischenbandsignale des empfangenen Signals folgt.

17. Encoder nach Anspruch 14, wobei die Filtermittel angeordnet sind, um Tonabschnitte unter Verwendung von verschobener diskreter Fouriertransformation zu erkennen.

18. Encoder nach Anspruch 14, wobei die Codierungsmittel angeordnet sind, um die Anzahl von Hochfrequenzzwischenändern für Tonabschnitte zu erhöhen.

19. Decoder zum Decodieren von Tonsignalen, umfassend:

Empfangsmittel, angeordnet zum Empfangen eines codierten Bitstreams;
Decodierungsmittel, angeordnet zum Decodieren von mindestens einem Niederfrequenzsignal und mindestens Parametern, die sich auf Niederfrequenzsignalabschnitte beziehen, aus dem Bitstream und zum Entpacken von Positionen und Amplituden von Sinuskurven aus dem Bitstream, wenn Positionen und Amplituden von Sinuskurven in dem Bitstream enthalten sind, wobei sich die Parameter mindestens auf die Niederfrequenzbandsignalabschnitte beziehen, die das höchste Ähnlichkeitsmaß bezüglich eines Hochfrequenzzwischenbandsignals aufweisen, um die Niederfrequenzbandsignalabschnitte auf eine Hochfrequenz zu transponieren, um die Hochfrequenzzwischenbänder zu rekonstruieren; und Erzeugungsmittel, die zur Nutzung von Samples des Niederfrequenzsignals und der Parameter, die sich auf die Niederfrequenzsignalabschnitte beziehen, angeordnet sind, und, wenn in dem Bitstream enthalten, Positionen und Amplituden der Sinuskurven zur Rekonstruktion von mindestens zwei Hochfrequenzzwischenbandsignalen, Ausgabemittel, die zum Ausgaben eines Ausgabetonsignals angeordnet sind, das das mindestens eine decodierte Niederfrequenzsignal und die mindestens zwei Hochfrequenzzwischenbandsignale umfasst,
wobei die mindestens zwei Hochfrequenzzwischenbänder aus dem mindestens einen decodierten Niederfrequenzsignal, den Parametern und, wenn in dem Bitstream enthalten, den Positionen und Amplituden der Sinuskurve rekonstruiert sind.

20. System für digitale Audiokompression, umfassend einen Decoder nach Anspruch 19, und einen Encoder nach Anspruch 14.

21. Computerprogrammprodukt zum Codieren von Tonsignalen, wobei das Programm Anweisungen umfasst, die bedienbar sind, um einen Prozessor zu veranlassen:

ein Eingabeaudiosignal zu empfangen;
das Eingabeaudiosignal in mindestens ein Niederfrequenzband und ein Hochfrequenzband zu unterteilen;
das Hochfrequenzbands in mindestens zwei Hochfrequenzzwischenbandsignale zu unterteilen;
ein Ähnlichkeitsmaß zwischen Niederfrequenzbandsignalabschnitten und den Hochfrequenzzwischenbandsignalen durch Vergleich von Niederfrequenzsignalsamples mit Hochfrequenzzwischenbändern des empfangenen Eingabeaudiosignals zu bestimmen;
Niederfrequenzsignalsamples des Niederfrequenzsignalbands zu codieren;
Erzeugen von Parametern, die sich mindestens auf die Niederfrequenzbandsignalabschnitte beziehen, die das höchste Ähnlichkeitsmaß bezüglich der Hochfrequenzzwischenbandsignale aufweisen, um die Niederfrequenzbandsignalabschnitte auf eine Hochfrequenz zu transponieren, um die Hochfrequenzzwischenbänder zu rekonstruieren;
Teilen des Eingabeaudiosignals in temporär sukzessive Rahmen;
Erkennen von Tonabschnitten innerhalb von zwei aufeinanderfolgenden Rahmen innerhalb des Eingabeaudiosignals, und, wenn Tonabschnitte erkannt werden, Hinzufügen von Sinuskurven zu der Hochfrequenzregion; und
Erzeugen eines Bitstreams mit den codierten Niederfrequenzsignalsamples, den Parametern und, wenn Tonabschnitte erkannt werden, von Positionen und Amplituden der Sinuskurve.

22. Computerprogrammprodukt nach Anspruch 21, wobei die Erkennung von Tonabschnitten die Verwendung einer verschobenen diskreten Fouriertransformation zur Erkennung von Tonabschnitten erfasst.

**23.** Computerprogrammprodukt nach Anspruch 21, bedienbar, einen Prozessor zu veranlassen, die Anzahl von Hochfrequenzzwischenbändern für Tonabschnitte zu erhöhen.

**24.** Computerprogrammprodukt zum Decodieren von Bitstreams, wobei das Programm Anweisungen umfasst, die bedienbar sind, um einen Prozessor zu veranlassen:

Empfangen eines codierten Bitstreams;
Decodieren von mindestens einem Niederfrequenzsignal und mindestens Parametern, die sich auf Niederfrequenzsignalabschnitte beziehen, aus dem Bitstream wobei sich die Parameter mindestens auf die Niederfrequenzbandsignalabschnitte beziehen, die das höchste Ähnlichkeitsmaß bezüglich des Hochfrequenzzwischenbandsignals aufweisen, um die Niederfrequenzbandsignalabschnitte auf eine Hochfrequenz zu transponieren, um die Hochfrequenzzwischenbänder zu rekonstruieren;
Entpacken von Positionen und Amplituden der Sinuskurve von dem Bitstream, wenn Positionen und Amplituden von Sinuskurven in dem Bitstream enthalten sind,
Verwendung von Samples des Niederfrequenzsignals und der Parameter, die sich auf die Niederfrequenzsignalabschnitte beziehen und, wenn sie in dem Bitstream enthalten sind, Positionen und Amplituden von Sinuskurven zur Rekonstruktion von mindestens zwei Hochfrequenzzwischenbandsignalen, wobei die mindestens zwei Hochfrequenzzwischenbänder aus dem mindestens einen decodierten Niederfrequenzsignal, den Parametern und, wenn in dem Bitstream enthalten, den Positionen und Amplituden der Sinuskurve rekonstruiert sind.

**Revendications**

**1.** Procédé de codage de signaux audio avec :

la réception d'un signal audio d'entrée ;
la division du signal audio d'entrée en au moins une bande de fréquence basse et une bande de fréquence élevée ;
la division de la bande de fréquence élevée en deux signaux de sous-bande de fréquence élevée, ou plus ;
la détermination d'une mesure de similarité entre des sections de signaux de bande de fréquence basse et les signaux de sous-bande de fréquence élevée en comparant des échantillons de signaux de fréquence basse à des sous-bandes de fréquence élevée du signal audio d'entrée reçu ;
le codage d'échantillons de signaux de fréquence basse de la bande de signal de fréquence basse ;
la génération de paramètres qui font référence au moins aux sections de signaux de bande de fréquence basse ayant la mesure de similarité la plus élevée par rapport aux signaux de sous-bande de fréquence élevée, pour transposer les sections de signaux de bande de fréquence basse à une fréquence élevée afin de reconstruire les sous-bandes de fréquence élevée ;
la division du signal audio d'entrée en trames successives temporellement ;
la détection de sections tonales au sein des deux trames successives dans le signal audio d'entrée et, si des sections tonales sont détectées, l'ajout de sinusoïdes à la région de fréquence élevée ; et
la création d'un flux binaire ayant les échantillons de signaux de fréquence basse codés, les paramètres et, si des sections tonales sont détectées, les positions et les amplitudes des sinusoïdes.

**2.** Procédé selon la revendication 1, dans lequel la génération des paramètres comprend en outre la génération d'au moins un facteur de mise à l'échelle pour mettre à l'échelle les sections de signaux de bande de fréquence basse.

**3.** Procédé selon la revendication 2, dans lequel le facteur de mise à l'échelle est généré de telle sorte qu'une enveloppe des sections de signaux de fréquence basse qui est transposée dans les signaux de sous-bande de fréquence élevée à l'aide des paramètres suit une enveloppe du signal de sous-bande de fréquence élevée du signal audio d'entrée reçu.

**4.** Procédé selon la revendication 2, dans lequel la génération de facteurs de mise à l'échelle comprend la génération de facteurs de mise à l'échelle dans le domaine linéaire pour correspondre au moins aux pics d'amplitude dans le spectre.

**5.** Procédé selon la revendication 2, dans lequel la génération de facteurs de mise à l'échelle comprend la génération de facteurs de mise à l'échelle dans le domaine logarithmique pour correspondre au moins à l'énergie et/ou à la forme du spectre.

**6.** Procédé selon la revendication 1, dans lequel la génération de paramètres comprend la génération de liaisons vers des sections de signaux de fréquence basse qui représentent les signaux de sous-bande de fréquence élevée correspondants.

**7.** Procédé selon la revendication 1, dans lequel la détermination dans les sections de signaux de bande de fréquence basse qui correspondent le mieux aux signaux de sous-bande de fréquence élevée comprend l'utilisation d'au moins un élément parmi :

A) une corrélation normalisée,
B) une distance euclidienne.

**8.** Procédé selon la revendication 1, dans lequel au moins des échantillons des sections de signaux de fréquence basse sont générés en utilisant une transformation en cosinus discrète modifiée.

**9.** Procédé selon la revendication 1, comprenant en outre la normalisation de l'enveloppe des signaux de sous-bande de fréquence élevée.

**10.** Procédé selon la revendication 2, comprenant en outre la quantification d'échantillons du signal de fréquence basse et la quantification au moins des facteurs de mise à l'échelle.

**11.** Procédé selon la revendication 1, dans lequel la détection de sections tonales comprend l'utilisation d'une transformée de Fourier discrète décalée.

**12.** Procédé selon la revendication 1, comprenant en outre l'augmentation du nombre de sous-bandes de fréquence élevée pour des sections tonales.

**13.** Procédé de décodage de signaux audio avec :

la réception d'un flux binaire codé ;
le décodage à partir du flux binaire d'au moins un signal de fréquence basse et au moins des paramètres faisant référence aux sections de signaux de fréquence basse, et dans lequel les paramètres font référence au moins aux sections de signaux de bande de fréquence basse ayant la mesure de similarité la plus élevée par rapport à un signal de sous-bande de fréquence élevée, pour transposer les sections de signaux de bande de fréquence basse à une fréquence élevée afin de reconstruire les sous-bandes de fréquence élevée ;
l'extraction à partir des positions du flux binaire et des amplitudes des sinusoïdes si les positions et les amplitudes des sinusoïdes sont comprises dans le flux binaire,
l'utilisation d'échantillons du signal de fréquence basse et des paramètres faisant référence aux sections de signaux de fréquence basse et, si comprises dans le flux binaire, des positions et des amplitudes des sinusoïdes pour reconstruire deux signaux de sous-bande de fréquence élevée, ou plus ; et
l'émission d'un signal audio de sortie comprenant au moins le signal de fréquence basse et les deux signaux de sous-bande de fréquence élevée, ou plus, dans lequel les deux sous-bandes de fréquence élevée, ou plus, sont reconstruites à partir de l'au moins un signal de fréquence basse décodé, des paramètres, et si comprises dans le flux binaire, des positions et des amplitudes des sinusoïdes.

**14.** Codeur permettant de coder des signaux audio comprenant :

un moyen de réception agencé pour recevoir un signal audio d'entrée ;
un moyen de filtrage agencé pour diviser le signal audio d'entrée en au moins une bande de fréquence basse et une bande de fréquence élevée, pour diviser la bande de fréquence élevée en deux signaux de sous-bande de fréquence élevée, ou plus, et agencé en outre pour diviser le signal audio d'entrée en trames successives temporellement, pour détecter des sections tonales dans deux trames successives dans le signal audio d'entrée ; et
un moyen de codage agencé pour déterminer une mesure de similarité entre des sections de signaux de bande de fréquence basse et les signaux de sous-bande de fréquence élevée en comparant des échantillons de signaux de fréquence basse aux sous-bandes de fréquence élevée du signal audio d'entrée reçu, pour générer des paramètres qui font référence au moins aux sections de signaux de bandes de fréquence basse ayant la mesure de similarité la plus élevée par rapport aux signaux de sous-bandes de fréquence élevée, pour transposer les sections de signaux de bande de fréquence basse à une fréquence élevée afin de reconstruire les sous-bandes de fréquence élevée, et si des sections tonales sont détectées, ajouter des sinusoïdes à la région de fréquence élevée, le moyen de codage est agencé en outre pour coder des échantillons de signaux de fréquence basse de la bande de signal de fréquence basse, et

un moyen de sortie pour créer un flux binaire avec les échantillons de signaux de fréquence basse codés, les paramètres et, si des sections tonales sont détectées, des positions et des amplitudes des sinusoïdes.

15. Codeur selon la revendication 14, dans lequel les moyens de codage sont agencés pour générer au moins un facteur de mise à l'échelle pour mettre à l'échelle les sections de signaux de bande de fréquence basse.

16. Codeur selon la revendication 14, dans lequel les moyens de codage sont agencés pour générer le facteur de mise à l'échelle de telle sorte qu'une enveloppe des sections de signaux de fréquence basse qui est transposée dans les signaux de sous-bande de fréquence élevée à l'aide des paramètres suit une enveloppe des signaux de sous-bande de fréquence élevée du signal reçu.

17. Codeur selon la revendication 14, dans lequel les moyens de filtrage sont agencés pour détecter des sections tonales à l'aide d'une transformée de Fourier discrète décalée.

18. Codeur selon la revendication 14, dans lequel les moyens de codage sont agencés pour augmenter le nombre de sous-bandes de fréquence élevée pour des sections tonales.

19. Décodeur permettant de décoder des signaux audio comprenant :

des moyens de réception agencés pour recevoir un flux binaire codé ;
des moyens de décodage agencés pour décoder à partir du flux binaire au moins un signal de fréquence basse et au moins des paramètres faisant référence aux sections de signaux de fréquence basse, et pour extraire à partir des positions du flux binaire et des amplitudes des sinusoïdes si les positions et les amplitudes des sinusoïdes sont comprises dans le flux binaire, dans lequel les paramètres font référence au moins aux sections de signaux de bande de fréquence basse ayant la mesure de similarité la plus élevée par rapport à un signal de sous-bande de fréquence élevée, pour transposer les sections de signaux de bande de fréquence basse à une fréquence élevée afin de reconstruire les sous-bandes de fréquence élevée ; et
des moyens de génération agencés pour utiliser des échantillons du signal de fréquence basse et les paramètres faisant référence aux sections de signaux de fréquence basse et, si comprises dans le flux binaire, des positions et des amplitudes des sinusoïdes afin de reconstruire deux signaux de sous-bande de fréquence élevée, ou plus ;
des moyen d'émission agencés pour émettre un signal audio de sortie comprenant l'au moins un signal de fréquence basse décodé et les deux signaux de sous-bande de fréquence élevée, ou plus,
dans lequel les deux sous-bandes de fréquence élevée, ou plus, sont reconstruites à partir de l'au moins un signal de fréquence basse décodé, des paramètres, et si comprises dans le flux binaire, des positions et des amplitudes des sinusoïdes.

20. Système destiné à une compression audio numérique comprenant un décodeur selon la revendication 19, et un codeur selon la revendication 14.

21. Produit de programme informatique permettant de coder des signaux audio, le programme comprenant des instructions opérationnelles pour amener un processeur à :

recevoir un signal audio d'entrée ;
diviser le signal audio d'entrée en au moins une bande de fréquence basse et une bande de fréquence élevée ;
diviser la bande de fréquence élevée en deux signaux de sous-bande de fréquence élevée, ou plus ;
déterminer une mesure de similarité entre des sections de signaux de bande de fréquence basse et les signaux de sous-bande de fréquence élevée en comparant des échantillons de signaux de fréquence basse à des sous-bandes de fréquence élevée du signal audio d'entrée reçu ;
coder des échantillons de signaux de fréquence basse de la bande de signal de fréquence basse ;
générer des paramètres qui font référence au moins aux sections de signaux de bande de fréquence basse ayant la mesure de similarité la plus élevée par rapport aux signaux de sous-bande de fréquence élevée, pour transposer les sections de signaux de bande de fréquence basse à une fréquence élevée afin de reconstruire les sous-bandes de fréquence élevée ;
diviser le signal audio d'entrée en trames successives temporellement ;
détecter des sections tonales au sein des deux trames successives dans le signal audio d'entrée et, si des sections tonales sont détectées, l'ajout de sinusoïdes à la région de fréquence élevée ; et
la création d'un flux binaire ayant les échantillons de signaux de fréquence basse codés, les paramètres et, si les sections tonales sont détectées, les positions et les amplitudes des sinusoïdes.

22. Produit de programme informatique selon la revendication 21, dans lequel la détection de sections tonales comprend l'utilisation d'une transformation de Fourier discrète décalée pour détecter des sections tonales.

23. Produit de programme informatique selon la revendication 21, opérationnel pour amener un processeur à augmenter le nombre de sous-bandes de fréquence élevée pour des sections tonales.

24. Produit de programme informatique permettant de décoder des flux binaires, le programme comprenant des instructions opérationnelles pour amener un processeur à :

recevoir un flux binaire codé ;
décoder à partir du flux binaire au moins un signal de fréquence basse et au moins des paramètres faisant référence aux sections de signaux de fréquence basse, dans lequel les paramètres font référence au moins aux sections de signaux de bande de fréquence basse ayant la mesure de similarité la plus élevée par rapport à un signal de sous-bande de fréquence élevée, pour transposer les sections de signaux de bande de fréquence basse à une fréquence élevée afin de reconstruire les sous-bandes de fréquence élevée ;
extraire à partir des positions du flux binaire et des amplitudes des sinusoïdes si les positions et les amplitudes des sinusoïdes sont comprises dans le flux binaire ;
utiliser des échantillons du signal de fréquence basse et les paramètres faisant référence aux sections de signaux de fréquence basse et, si comprises dans le flux binaire, des positions et des amplitudes des sinusoïdes pour reconstruire deux signaux de sous-bande de fréquence élevée, ou plus ; et
émettre un signal audio de sortie comprenant au moins le signal de fréquence basse et les deux signaux de sous-bande de fréquence élevée, ou plus, dans lequel les deux sous-bandes de fréquence élevée, ou plus, sont reconstruites à partir de l'au moins un signal de fréquence basse décodé, des paramètres et, si comprises dans le flux binaire, des positions et des amplitudes des sinusoïdes.

FIG. 1

FIG. 2

FIG. 3

*32*

SBR additional
component
extraction

*34*

Envelope
extraction

*22*

Bitstream
formatting

*12*

*10*

*30*

Low pass
filtering and
downsampling

Low frequency
coder

*31*

FIG. 4

*F 4*

*24*

*38*

Low frequency
decoder

*8*

*12*

Bitstream

Bitstream
unpacking

High frequency
reconstruction

Additional
components

Envelope
adjustment

Output

*14*

*40*  FIG. 5

*42*

*44*

FIG. 6

Fig. 7

Fig. 8

Fig. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1441330 A

**Non-patent literature cited in the description**

- **KJORLING ; O. KUNZ.** Spectral Band Replication, a novel approach in audio coding. *112th AES Convention,* May 2002

- **P. EKSTRAND.** Bandwidth extension of audio signals by spectral band replication. *1st IEEE Benelux Workshop on Model Based Processing and Coding of Audio,* November 2002